(19) Europäisches Patentamt / European Patent Office / Office européen des brevets

(11) **EP 3 807 733 B1**

(12) **EUROPÄISCHE PATENTSCHRIFT**

(45) Veröffentlichungstag und Bekanntmachung des Hinweises auf die Patenterteilung:
**22.02.2023 Patentblatt 2023/08**

(21) Anmeldenummer: **19724172.2**

(22) Anmeldetag: **10.05.2019**

(51) Internationale Patentklassifikation (IPC):
***G05B 23/02*** (2006.01)

(52) Gemeinsame Patentklassifikation (CPC):
**G05B 23/0256**

(86) Internationale Anmeldenummer:
**PCT/EP2019/062102**

(87) Internationale Veröffentlichungsnummer:
**WO 2019/238322 (19.12.2019 Gazette 2019/51)**

(54) **DIAGNOSE EINES ZWEI-LEITER FELDGERÄTS**

DIAGNOSIS OF A TWO-CONDUCTOR FIELD INSTRUMENT

DIAGNOSTIC D'UN APPAREIL DE TERRAIN À DEUX CONDUCTEURS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **14.06.2018 DE 102018114302**

(43) Veröffentlichungstag der Anmeldung:
**21.04.2021 Patentblatt 2021/16**

(73) Patentinhaber: **Endress+Hauser SE+Co. KG
79689 Maulburg (DE)**

(72) Erfinder:
• **FRÜHAUF, Dietmar
79539 Lörrach (DE)**
• **WERNET, Armin
79618 Rheinfelden (DE)**

(74) Vertreter: **Koslowski, Christine Adelheid
Endress+Hauser Group Services
(Deutschland) AG+Co. KG
Colmarer Straße 6
79576 Weil am Rhein (DE)**

(56) Entgegenhaltungen:
**EP-A2- 1 860 513    US-A1- 2005 168 343**

**Beschreibung**

Die Erfindung betrifft ein Verfahren zur Diagnose eines Zwei-Leiter Feldgeräts zur Bestimmung und/oder Überwachung zumindest einer Prozessgröße eines Mediums in einem Behältnis, sowie ein entsprechendes Zwei-Leiter Feldgerät. Bei dem Medium handelt es sich beispielsweise um ein Gas, eine Flüssigkeit, oder ein Schüttgut. Das Behältnis wiederum kann beispielsweise ein Behälter oder eine Rohrleitung sein.

Feldgeräte der Automatisierungstechnik dienen zur Erfassung und/oder Beeinflussung von unterschiedlichen Prozessvariablen. Dabei werden im Rahmen der vorliegenden Anmeldung alle Geräte als Feldgerät bezeichnet werden, die prozessnah eingesetzt werden und die prozessrelevante Informationen liefern oder verarbeiten.

Als Messgeräte zur Erfassung unterschiedlicher Prozessgrößen seien in diesem Zusammenhang beispielsweise Füllstandsmessgeräte, Durchflussmessgeräte, Druck- und Temperaturmessgeräte, pH- und/oder pH-Redoxpotentialmessgeräte, oder auch Leitfähigkeitsmessgeräte genannt, welche der Erfassung der jeweils entsprechenden Prozessgrößen Füllstand, Durchfluss, Druck, Temperatur, pH-Wert, Redoxpotential, oder Leitfähigkeit dienen. Die jeweiligen Messprinzipien solcher Feldgeräte sind aus dem Stand der Technik hinlänglich bekannt, und werden an dieser Stelle nicht einzeln angeführt. Je nach angewendetem Messprinzip wird beispielsweise im Fall von Durchflussmessgeräten zwischen Coriolis-, Ultraschall-, Vortex-, thermischen und/oder magnetisch induktiven Durchflussmessgeräten unterschieden. Als Füllstandsmessgeräte werden insbesondere Mikrowellen-Füllstandsmessgeräte, Ultraschall-Füllstandsmessgeräte, zeitbereichsreflektometrische Füllstandsmessgeräte (TDR), radiometrische Füllstandsmessgeräte, kapazitive Füllstandsmessgeräte, konduktive Füllstandsmessgeräte und/oder temperatursensitive Füllstandsmessgeräte eingesetzt. Bei Druckmessgeräten dagegen handelt es sich bevorzugt um sogenannte Absolut-, Relativ- oder Differenzdruckmessgeräte, während Temperaturmessgeräte häufig Thermoelemente oder temperaturabhängige Widerstände zur Ermittlung der Temperatur aufweisen.

Zur Beeinflussung von Prozessvariablen dienen wiederum in der Regel Aktoren, Ventile, und/oder Pumpen, mittels welchen beispielsweise der Durchfluss durch eine Rohrleitung oder ein Füllstand in einem Behälter beeinflusst werden kann.

Im Rahmen der vorliegenden Anmeldung werden im Prinzip auch Remote I/Os, Funkadapter bzw. allgemein elektronische Komponenten, die auf der Feldebene angeordnet sind, bezeichnet.

Eine Vielzahl der genannten Beispiele für Feldgeräte wird von Firmen der Endress + Hauser-Gruppe hergestellt und vertrieben.

In größeren Industrieanlagen werden Feldgeräte häufig über Bussysteme, wie z. B. Profibus, oder Foundation Fieldbus, mit übergeordneten Einheiten, beispielsweise Leitsysteme oder Steuereinheiten, verbunden. Diese Einheiten dienen unter anderem der Prozesssteuerung, - visualisierung, -überwachung und/oder zur Inbetriebnahme der Feldgeräte.

In gefährdeten Bereichen, insbesondere in explosionsgefährdeter Atmosphäre, kommen bevorzugt sogenannte Zwei-Leiter Feldbusse, wie z. B. Profibus-PA oder Foundation Fieldbus, zum Einsatz. Im Falle solcher Bussysteme erfolgt sowohl die Energieversorgung des Zwei-Leiter Feldgeräts als auch die Datenübertragung vom Feldgerät (Slave) zur übergeordneten Einheit (Master) über dasselbe Leiterpaar. Zur Übertragung von Messdaten vom Feldgerät an die übergeordnete Einheit wird der Stromfluss durch das Feldgerät moduliert. Durch eine Analyse der Strommodulation kann die übergeordnete Einheit verschiedene Daten, insbesondere die Messdaten, vom Feldgerät erhalten.

Stromschleifen zur Datenübertragung sind häufig für 4-20mA Schnittstellen oder auch gemäß dem NAMUR Standard ausgelegt. Im Falle einer 4-20mA Schnittstelle werden die Messdaten auf einen Strom im Bereich zwischen 4mA und 20mA abgebildet. Darüber hinaus können mittels der Stromschleife auch Fehlerinformationen übertragen werden. Beispielsweise kann ausgewertet werden, ob der jeweilige Schleifenstrom zu groß oder zu klein ist und entsprechend nicht mehr als Messwert interpretiert werden sollte. Entspricht der Strom einem vorgebbaren Fehlerstrom, wird dann ein Alarm ausgegeben. Als vorgebbare Fehlerströme werden dabei Stromwerte gewählt, welche außerhalb des 4-20mA-Bereichs liegen. Typische Werte sind beispielsweise 3.6 mA für einen sogenannten "low-alarm" und 22 mA für einen sogenannten "high-alarm".

Für viele Anwendungen, insbesondere im Falle von sicherheitskritischen Anwendungen, ist es von großer Bedeutung, dass die Messwertübertragung sowie die Übertragung von Fehlerinformationen zuverlässig möglich ist. Um dies zu gewährleisten, definieren beispielsweise die Normen IEC 61508, oder IEC 61511 verschiedene Anforderungen, welchen die jeweiligen Feldgeräte genügen müssen. Zur Gewährleistung einer hohen funktionalen Sicherheit im Zusammenhang mit Zwei-Leiter-Feldgeräten ist im Stand der Technik beispielsweise bekannt geworden, zu überwachen, ob ein in einer Stromschleife eingestellter Strom dem tatsächlichen Wert der zu repräsentierenden Messgröße entspricht. In diesem Zusammenhang sind unterschiedliche Maßnahmen, wie beispielsweise die in den Dokumenten US2005/168343A1, EP1860513A1, US7098798B2, oder DE02008001832A1 beschriebenen, vorgeschlagen worden.

Ausgehend vom Stand der Technik liegt der vorliegenden Erfindung die Aufgabe zugrunde, auf einfache Weise eine hohe funktionale Sicherheit für ein Zwei-Leiter Feldgeräte bereitzustellen.

Diese Aufgabe wird gelöst durch das Verfahren nach Anspruch 1 sowie durch das Zwei-Leiter Feldgerät nach Anspruch 4. Vorteilhafte Ausgestaltungen sind jeweils in den abhängigen Ansprüchen angegeben.

Bezüglich des Verfahrens wird die der Erfindung zugrundeliegende Aufgabe gelöst durch ein Verfahren zur Diagnose eines Zwei-Leiter-Feldgeräts zur Bestimmung und/oder Überwachung zumindest einer Prozessgröße eines Mediums in einem Behälter. In einem Normalbetriebsmodus wird eine Eingangsspannung bereitgestellt und ein Ausgangsstrom ausgegeben. In einem Diagnosebetriebsmodus wird eine Funktionalität des Zwei-Leiter-Feldgeräts überprüft wird, wobei der Diagnosebetriebsmodus zumindest folgende Verfahrensschritte umfasst:

Bereitstellen einer ersten Diagnose-Eingangsspannung und Ausgeben eines ersten Diagnose-Ausgangsstroms während eines ersten Zeitintervalls,
Bereitstellen einer zweiten Diagnose-Eingangsspannung und Ausgeben eines zweiten Diagnose-Ausgangsstroms während eines zweiten Zeitintervalls,
Bestimmen des zweiten Zeitintervalls ausgehend vom ersten Zeitintervall,
Erfassen einer ersten und/oder zweiten Diagnose-Ausgangsspannung in Abhängigkeit vom ersten und/oder zweiten Diagnose-Ausgangsstrom, und
Überprüfen der Funktionalität des Zwei-Leiter-Feldgeräts zumindest anhand der ersten und/oder zweiten Diagnose-Eingangsspannung, dem ersten und/oder zweiten Zeitintervall, des ersten und/oder zweiten Diagnose-Ausgangsstroms, der ersten und/oder zweiten Diagnose-Ausgangsspannung, anhand der Eingangsspannung und/oder anhand des Ausgangsstroms, wobei das zweite Zeitintervall ($t_2$) ausgehend vom ersten Zeitintervall ($t_1$) derart bestimmt wird, dass ein Wert eines ersten Integrals einer Differenz zwischen der Eingangsspannung ($U_N$) und der ersten Diagnose-Eingangsspannung ($U_{DE,1}$) über das erste Zeitintervall ($t_1$) und ein Wert eines zweiten Integrals einer Differenz der Eingangsspannung ($U_N$) und der zweiten Diagnose-Eingangsspannung ($U_{DE,2}$) über das zweite Zeitintervall ($t_2$) im Wesentlichen vom Betrag her gleich sind.

Die Eingangsspannung und/oder der Ausgangsstrom im Normalbetriebsmodus repräsentieren die jeweilige Prozessgröße. Während des Diagnosebetriebsmodus ergibt sich vorteilhaft eine gleichanteilsfreie Modulation des Ausgangsstroms. Das zeitliche Integral über die Dauer des Diagnosebetriebsmodus, also über das erste und zweite Zeitintervall, ist null.

Der Normalbetriebsmodus und der Diagnosebetriebsmodus können beispielsweise abwechselnd, bzw. intermittierend, durchgeführt werden. Das Verfahren und/oder das jeweilige Feldgerät kann/können aber auch derart beschaffen sein, dass der Diagnosebetriebsmodus manuell auslösbar ist, beispielsweise durch Betätigen eines Schaltelements durch das jeweilige Bedienpersonal. Ebenso ist es möglich, den Diagnosebetriebsmodus quasi zeitgleich zum Normalbetriebsmodus durchzuführen. In diesem Zusammenhang ist es vorteilhaft, wenn die beiden Zeitintervalle für den Diagnosebetriebsmodus hinreichend kurz gewählt sind, bevorzugt, wenn die Zeitintervalle im Bereich von wenigen Millisekunden bis hin zu ca. 100 Millisekunden liegen. So kann die Trägheit einer übergeordneten Einheit, zu welcher der Ausgangsstrom übertragen wird, ausgenutzt werden. Die übergeordnete Einheit registriert dann im Prinzip nicht, dass das Feldgerät zeitweise in einem Diagnosebetriebsmodus betrieben wird.

Das zweite Zeitintervall kann beispielsweise anhand des ersten Zeitintervalls und zumindest einer weiteren Größe, beispielsweise der ersten und/oder zweiten Diagnose-Eingangsspannung und/oder der Eingangsspannung im Normalbetriebsmodus, berechnet werden.

Vorteilhaft lassen sich mittels des erfindungsgemäßen Verfahrens unterschiedliche Funktionalitäten des Feldgeräts überprüfen. Auf diese Weise kann eine hohe funktionale Sicherheit des entsprechenden Feldgeräts gewährleistet werden. Beispielsweise kann überprüft werden, ob Fehlerinformationen korrekt übertragen werden, oder ob ein in der Stromschleife eingestellter Strom, der Ausgangsstrom, dem tatsächlichen Wert der zu repräsentierenden Messgröße entspricht. Auch lassen sich ggf. Rückschlüsse auf die Funktionalität einzelner Komponenten des Feldgeräts ziehen.

In einer bevorzugten Ausgestaltung wird überprüft, ob mittels des Zwei-Leiter-Feldgeräts ein vorgebbarer Fehlerstrom, insbesondere ein vorgebbarer Maximalwert oder ein vorgebbarer Minimalwert für den Ausgangsstrom ausgebbar ist. Es lässt sich also beispielsweise überprüfen, ob der in der Beschreibungseinleitung bereits erwähnte "high-alarm" und/oder der "low-alarm" ausgebbar ist/sind.

Alternativ oder zusätzlich hierzu beinhaltet eine weitere bevorzugte Ausgestaltung, dass überprüft wird, ob ein zu einer vorgebbaren Eingangsspannung gehöriger Ausgangsstrom mit einem Fehler behaftet ist. Es lässt sich in diesem Zusammenhang also beispielsweise überprüfen, ob ein in der Stromschleife eingestellter Strom, der Ausgangsstrom, dem tatsächlichen Wert der zu repräsentierenden Messgröße entspricht.

Außerdem kann überprüft werden, ob ein Defekt in der Elektronik, insbesondere an einer Komponente der Elektronik, vorliegt. Beispielsweise kann anhand der ersten und/oder zweiten Diagnoseausgangsspannung oder anhand eines Verlaufs der ersten und/oder zweiten Diagnoseausgangsspannung während des ersten und/oder zweiten Zeitintervalls eine Aussage über die Funktionalität der Elektronik, insbesondere einer Komponente der Elektronik, gemacht werden.

Die Überprüfung der Funktionalität des Zwei-Leiter-Feldgeräts kann beispielsweise durch eine direkte Überprüfung der ersten und/oder zweiten Diagnose-Eingangsspannung, dem ersten und/oder zweiten Zeitintervall, dem ersten und/oder zweiten Diagnose-Ausgangsstroms und/oder der ersten und/oder zweiten Diagnose-Ausgangsspannung, beispielsweise anhand eines Vergleichs mit einem oder mehreren Referenzwerten, erfolgen. Andererseits kann aber auch eine indirekte Überprüfung vorgenommen werden, bei welcher Erwartungswerte für zumindest eine bestimmte Größe, beispielsweise das zweite Zeitintervall, ermittelt werden, mittels welchen beispielsweise ein Vergleich mit den wiederum jeweils im fortlaufenden Betrieb ermittelten Werten durchgeführt und eine gegebenenfalls auftretende Abweichung bestimmt wird. Es sei darauf verwiesen, dass neben den beschriebenen Möglichkeiten noch zahlreiche weitere Methoden zur Überprüfung der Funktionalität des Zwei-Leiter-Feldgeräts denkbar sind, welche ebenfalls unter die vorliegende Erfindung fallen.

Eine Ausgestaltung des erfindungsgemäßen Verfahrens beinhaltet weiterhin, dass das zweite Zeitintervall in Abhängigkeit der Eingangsspannung bestimmt wird.

Die der Erfindung zugrundeliegende Aufgabe wird außerdem gelöst durch ein Zwei-Leiter-Feldgerät zur Bestimmung und/oder Überwachung zumindest einer Prozessgröße eines Mediums in einem Behälter umfassend eine Elektronik mit einer Diagnoseeinheit. Die Elektronik ist dazu ausgestaltet ist, in einem Normalbetriebsmodus eine Eingangsspannung bereitzustellen und einen Ausgangsstrom auszugeben, und in einem Diagnosebetriebsmodus eine Funktionalität des Zwei-Leiter-Feldgeräts zu überprüfen. Die Diagnoseeinheit ist dazu ausgestaltet,

während eines ersten Zeitintervalls eine erste Diagnose-Eingangsspannung bereitzustellen und einen ersten Diagnose-Ausgangsstrom auszugeben,
während eines zweiten Zeitintervalls eine zweite Diagnose-Eingangsspannung bereitzustellen und einen zweiten Diagnose-Ausgangsstrom auszugeben,
das zweite Zeitintervall zumindest ausgehend vom ersten Zeitintervall zu bestimmen,
in Abhängigkeit vom ersten und/oder zweiten Diagnose-Ausgangsstrom eine erste und/oder zweite Diagnose-Ausgangsspannung zu erfassen, und

anhand der ersten und/oder zweiten Diagnose-Eingangsspannung, dem ersten und/oder zweiten Zeitintervall, des ersten und/oder zweiten Diagnose-Ausgangsstroms, der ersten und/oder zweiten Diagnose-Ausgangsspannung, anhand der Eingangsspannung und/oder anhand des Ausgangsstroms die Funktionalität des Zwei-Leiter-Feldgeräts zu überprüfen.

In einer Ausgestaltung umfasst die Elektronik zumindest ein Schaltelement. Beispielsweise kann zumindest ein Schaltelement zur Aktivierung bzw. Deaktivierung des Diagnosebetriebsmodus vorgesehen sein. Ein Schaltelement kann zusätzlich oder außerdem dazu dienen, zwischen der ersten Diagnose-Eingangsspannung und der zweiten Diagnose-Eingangsspannung hin und her zu schalten. Es versteht sich von selbst, dass weitere Schaltelemente vorhanden sein können, die weitere Schaltfunktionen übernehmen.

Eine Ausgestaltung des Feldgeräts beinhaltet weiterhin, dass die Elektronik zumindest einen Widerstand umfasst, welcher zur Erzeugung der ersten und/oder zweiten Diagnose-Ausgangsspannung dient.

In einer weiteren Ausgestaltung umfasst die Diagnoseeinheit eine Recheneinheit, welche Recheneinheit dazu ausgestaltet ist, das zweite Zeitintervall zumindest anhand des ersten Zeitintervalls zu ermitteln. In der Recheneinheit kann beispielsweise eine Formel zur Bestimmung des zweiten Zeitintervalls hinterlegt sein. Das mittels der Recheneinheit ermittelte zweite Zeitintervall kann beispielsweise auch als Erwartungswert dienen.

Alternativ oder darüber hinaus kann das zweite Zeitintervall in einer anderen Ausgestaltung aber auch ohne Zuhilfenahme einer Recheneinheit auf analogem Wege bestimmt werden.

So beinhaltet eine weitere Ausgestaltung, dass die Diagnoseeinheit eine Steuereinheit umfasst, welche Steuereinheit zumindest eine Subtrahier-Einheit, eine Integrator-Einheit und einen Komparator aufweist. Mittels der Steuereinheit lässt sich das zweite Zeitintervall ausgehend vom ersten Zeitintervall bestimmen.

In dieser Hinsicht ist es von Vorteil, wenn die Integrator-Einheit zumindest einen Kondensator und einen Widerstand umfasst. Es ist ebenso von Vorteil, wenn die Integrator-Einheit zumindest ein Schaltelement umfasst, welches beispielsweise derart angeordnet und/oder ausgestaltet ist, dass die Integrator-Einheit durch ein Betätigen des Schaltelements vor Beginn des Diagnosebetriebsmodus in einen vorgebbaren Ausgangszustand versetzbar ist.

Bezüglich der Subtrahier-Einheit ist es von Vorteil, wenn die Subtrahier-Einheit dazu ausgestaltet ist, die Differenz zwischen einem Referenzsignal und der Eingangsspannung zu ermitteln. In dieser Hinsicht ist es wiederum von Vorteil, wenn es sich bei dem Referenzsignal um die erste und/oder zweite Diagnose-Eingangsspannung oder um die erste und/oder zweite Diagnose-Ausgangsspannung handelt.

Bezüglich des Komparators ist es wiederum von Vorteil, wenn der Komparator dazu ausgestaltet ist, das zweite Zeitintervall anhand einer Eingangsspannung der Integrator-Einheit zu ermitteln. Insbesondere kann das zweite Zeitintervall anhand des Erreichens eines vorgebbaren Wertes für eine an dem Komparator anliegende Eingangsspannung bestimmt werden, beispielsweise anhand des Erreichens des Wertes für die am Komparator anliegende Eingangsspannung zu Beginn des ersten Zeitintervalls.

Eine weitere Ausgestaltung des erfindungsgemäßen Zwei-Leiter-Feldgeräts beinhaltet schließlich, dass die Elektronik einen monostabilen Multivibrator umfasst.

Es sei darauf verwiesen, dass die in Zusammenhang mit dem erfindungsgemäßen Verfahren beschriebenen Ausgestaltungen mutatis mutandis auch auf das erfindungsgemäße Feldgerät anwendbar sind und umgekehrt.

Die Erfindung sowie ihre vorteilhaften Ausgestaltungen werden nachfolgend anhand der Figuren Fig. 1 - Fig. 6 näher beschrieben. Es zeigt:

Fig. 1: eine schematische Skizze eines in Form eines Zwei-Leiter-Feldgeräts realisierten, vibronischen Sensors gemäß Stand der Technik,

Fig. 2: eine schematische Skizze eines in Form eines Zwei-Leiter-Feldgeräts realisierten, kapazitiven und/oder konduktiven Füllstandsmessgeräts gemäß Stand der Technik,

Fig. 3: eine erste Ausgestaltung für eine erfindungsgemäße Diagnoseeinheit,

Fig. 4: eine zweite Ausgestaltung für eine erfindungsgemäße Diagnoseeinheit,

Fig. 5: eine dritte Ausgestaltung für eine erfindungsgemäße Diagnoseeinheit, und

Fig. 6 schematische Diagramme des zeitlichen Verlaufs des Ausgangsstroms, der mit der ersten und zweiten Diagnose-Eingangsspannung moduliert ist, für unterschiedliche Werte des Ausgangsstroms im Normalbetriebsmodus.

In den Figuren werden gleiche Elemente mit gleichen Bezugszeichen versehen.

Die vorliegende Erfindung bezieht sich allgemein auf Zwei-Leiter Feldgeräte. Bei solchen Feldgeräten kann es sich, wie in der Beschreibungseinleitung bereits erwähnt, um unterschiedlichste Geräte handeln. Beispielhaft wird im Folgenden kurz die Funktionsweise eines vibronischen Sensors und eines kapazitiven und/oder konduktiven Feldgeräts erläutert, welche beide in Form eines Zwei-Leiter-Feldgeräts ausgestaltet sind. Die vorliegende Erfindung ist jedoch keineswegs auf die beschriebenen Gattungen von Feldgeräten beschränkt.

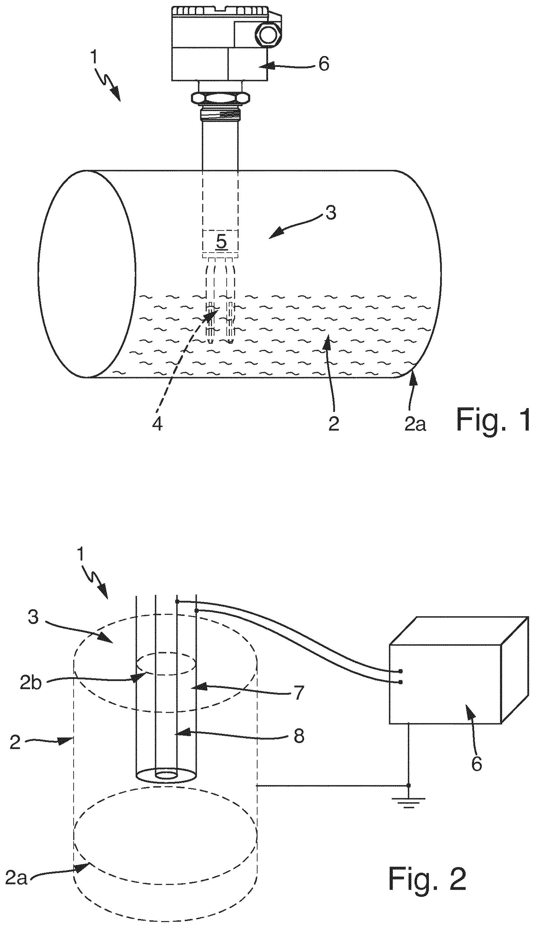

In Fig. 1 ist ein Feldgerät 1 in Form eines vibronischen Sensors gezeigt, mittels welchem beispielsweise ein vorgegebener Füllstands eines Mediums 2 in einem Behälter 2a überwacht werden kann, oder auch die Dichte und/oder Viskosität des Mediums 2 ermittelt werden kann. Die Sensoreinheit 3 umfasst eine mechanisch schwingfähige Einheit 4 in Form einer Schwinggabel, welche teilweise in das Medium 2 eintaucht. Andere bekannte und unter die Erfindung fallende Ausgestaltungen einer mechanisch schwingfähigen Einheit 4 sind beispielsweise durch einen Einstab oder eine Membran gegeben. Die mechanisch schwingfähige Einheit 4 wird mittels der Antriebs-/Empfangseinheit 5, welche mit dem Anregesignal beaufschlagt wird, zu mechanischen Schwingungen angeregt. Diese kann beispielsweise ein Vier-Quadranten-Antrieb oder ein Bimorphantrieb sein. Weiterhin ist eine Elektronik 6 dargestellt, mittels welcher die Signalauswertung und/oder-speisung erfolgt.

In Fig. 2 ist eine schematische Zeichnung eines typischen auf dem kapazitiven Messprinzip beruhenden Feldgeräts 1 gemäß Stand der Technik gezeigt. Das Beispiel zeigt eine Sensoreinheit 3 mit zwei zylinderförmig ausgestalteten Elektroden 7 und 8, welche von der über einen Prozessanschluss 2b von der Oberseite ausgehend in den teilweise mit Medium 2 gefüllten Behälter 2a hineinragt. Andere Ausgestaltungen kapazitiver und/oder konduktiver Messgeräte können selbstverständlich über eine andere Anzahl und/oder Ausgestaltung der Elektroden 7,8 verfügen. Weiterhin sind neben solchen Messgeräten 1, bei welchen die Sensoreinheit 3, wie in Fig. 2 dargestellt, von oben in den Behälter 2a hineinragen, auch solche Sensoreinheiten 3 bekannt geworden, welche über eine Seitenwandung des Behälters 2a in diesen eingebracht werden.

Die einem vibronischen und kapazitiven und/oder konduktiven Messgerät jeweils zugrundeliegenden Messprinzipien sind an sich hinlänglich aus dem Stand der Technik bekannt und werden deshalb an dieser Stelle nicht weiter erläutert.

Im Falle eines erfindungsgemäßen Feldgeräts 1 umfasst die Elektronik 6 eine Diagnoseeinheit 10, welche der Durchführung einer Ausgestaltung des erfindungsgemäßen Diagnosebetriebsmodus dient. Im Folgenden werden drei beispielhafte, besonders bevorzugte Ausgestaltungen für eine erfindungsgemäße Elektronikeinheit und für einen erfindungsgemäßen Diagnosebetriebsmodus erläutert. Es sei darauf verwiesen, dass die für die einzelnen Ausgestaltungen dargestellten Elemente auch ausgestaltungsübergreifend untereinander kombiniert werden können.

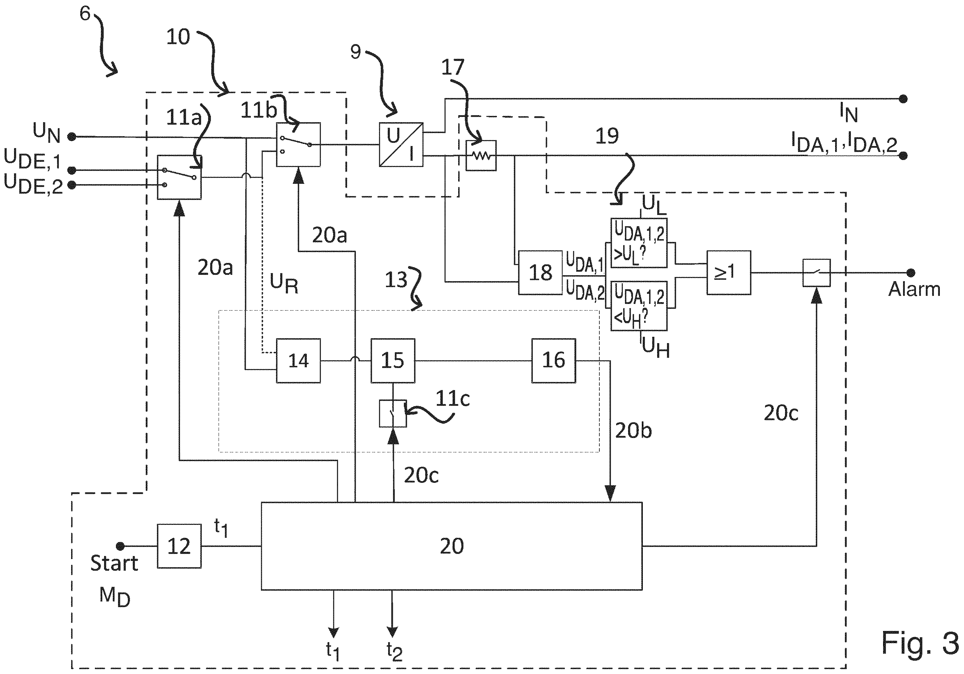

Eine erste mögliche Ausgestaltung ist in dem schematischen Blockschaltbild in Fig. 3 dargestellt. In einem Normmalbetriebsmodus $M_N$ wird eine Eingangsspannung $U_N$ erzeugt und ein für die jeweilige Prozessgröße repräsentativer Ausgangsstrom in ausgegeben. Die Elektronik 6 umfasst eine spannungsgesteuerte Stromquelle 9. Zum Ein- und Ausschalten des Diagnosebetriebsmodus $M_D$ umfasst die Diagnoseeinheit 10 zwei Schaltelemente 11a und 11b.

Zu Beginn des Diagnosebetriebsmodus $M_D$ wird mittels eines monostabilen Multivibrators 12 das erste Zeitintervall $t_1$ vorgegeben. Die Schaltelemente 11a und 11b werden passend eingestellt, so dass während des ersten Zeitintervalls die erste Diagnose-Eingangsspannung $U_{DE,1}$ bereitgestellt und über die spannungsgesteuerte Stromquelle 9 ein entsprechender Diagnose-Ausgangsstrom $I_{DA,1}$ ausgegeben wird.

Gleichzeitig wird mittels der Steuereinheit 13 das zweite Zeitintervall $t_2$ bestimmt. Die Steuereinheit 13 umfasst eine Subtrahier-Einheit 14, eine Integrator-Einheit 15 und einen Komparator 16. Die Integrator-Einheit 15 umfasst zumindest einen Kondensator C und einen Widerstand R. Außerdem verfügt sie über ein Schaltelement 11c, mittels welchem die Integrator-Einheit 15 vor Beginn des Diagnosebetriebsmodus $M_D$ in einen vorgebbaren Ausgangszustand versetzbar ist.

Mittels der Subtrahier-Einheit 14 wird die Differenz zwischen der Eingangsspannung $U_N$ im Normalbetriebsmodus $D_N$ und einem Referenzsignal $U_R$, welches im vorliegenden Fall durch die erste Diagnose-Eingangsspannung $U_{DE,1}$ gegeben ist, gebildet und der Integrator-Einheit 15 zugeführt. Die Ausgangsspannung der Integrator-Einheit 15 steigt dann, insbesondere linear, an, wobei der Anstieg der Spannung unter anderem von dem Wert der ersten Diagnose-Eingangsspannung $U_{DE,1}$, der Kapazität des Kondensators C und dem Widerstandswert des Widerstands R abhängt.

Nach dem ersten Zeitintervall $t_1$ werden die Schaltelemente 11a und 11b derart umgestellt, dass die zweite Diagnose-Eingangsspannung $U_{DE,2}$ bereitgestellt und ebenfalls ein entsprechender Ausgangsstrom $I_{DA,2}$ ausgegeben wird. Nun ist das Referenzsignal $U_R$ durch die zweite Diagnose-Eingangsspannung $U_{DE,2}$ gegeben. Als Konsequenz kehrt sich die Polarität der Differenz zwischen der Eingangsspannung $U_N$ und dem Referenzsignal $U_R$ um und die an der Integrator-Einheit 15 anliegende Spannung sinkt nun, insbesondere linear. Wieder hängt die Änderung der Spannung unter anderem von dem Wert der ersten Diagnose-Eingangsspannung $U_{DE,2}$, der Kapazität des Kondensators C und dem Widerstandswert des Widerstands R ab.

Mit Hilfe des Komparators 16 wird derjenige Zeitpunkt bestimmt, zu welchem ein Wert der am Komparator 16 anliegenden Spannung demjenigen Wert entspricht, welchen diese Spannung zu Beginn des ersten Zeitintervalls $t_1$ aufgewiesen hat. Dieser Zeitpunkt definiert das Ende des zweiten Zeitintervalls $t_2$. Vorteilhaft kann die Diagnoseeinheit 10, insbesondere die Steuereinheit 13, derart ausgestaltet sein, dass das Ende des zweiten Zeitintervalls $t_2$ anhand eines Nulldurchgangs der am Komparator 16 anliegenden Spannung bestimmbar ist. Vorteilhaft kann das zweite Zeitintervall durch die Steuereinheit 13, insbesondere durch die Integrator-Einheit 15, bestimmt werden.

Der während des ersten $t_1$ bzw. zweiten Zeitintervalls $t_2$ fließende Ausgangsstrom $I_{DA,1}$ bzw. $I_{DA,2}$ erzeugt über dem Widerstand 17 einen Spannungsabfall und nach Aufbereitung mittels der Subtrahier-Einheit 18 die erste $U_{DA,1}$ bzw. zweite Diagnose-Ausgangsspannung $U_{DA,2}$. Anhand der ersten und zweiten Diagnose-Ausgangsspannungen $U_{DA,1}$ und $U_{DA,2}$ wird für die in Fig. 3 gezeigte Ausgestaltung eine Funktionalität des Feldgeräts 1 überprüft. Die Diagnose-Ausgangsspannungen $U_{DA,1}$ und $U_{DA,2}$ werden zu diesem Zweck jeweils der Komparator-Einheit 19 zugeführt, welche während des Diagnosebetriebsmodus $M_D$ überprüft, ob ein vorgebbarer Maximalwert $U_H$ oder ein vorgebbarer Minimalwert $U_L$ für den ersten und/oder zweiten Ausgangsstrom $I_{DA,1}$ bzw. $I_{DA,2}$, bzw. für die erste und/oder zweite Diagnose-Ausgangsspannung $U_{DA,1}$ bzw. $U_{DA,2}$, ausgebbar ist. Ist dies nicht der Fall, so kann beispielsweise eine Fehlermeldung in Form eines Alarms von dem Feldgerät 1 ausgegeben werden.

Weiterhin umfasst die Diagnoseeinheit 10 im vorliegenden Beispiel eine Kontrolleinheit 20. Diese ist jedoch nicht zwingend notwendig. Mit der Kontrolleinheit 20 können verschiedene Handlungen ausgelöst werden. Beispielsweise können mittels der Kontrolleinheit 20 die Zeitintervalle $t_1$ und $t_2$ und entsprechend die Schaltelemente 11a und 11b gesteuert werden (20a). Das Ende des zweiten Zeitintervalls $t_2$ wird dabei mittels der Steuereinheit 13 ermittelt und der Kontrolleinheit 20 übermittelt (20b). Auch das der Integrator-Einheit zugeordnete Schaltelement 11c kann durch die Kontrolleinheit 20 gesteuert werden (20c). Schließlich ist die Kontrolleinheit 20 ferner dazu ausgestaltet, die jeweilige Fehlermeldung bezüglich der jeweils überprüften Funktionalität des Feldgeräts 1 freizugeben (20d). Im gezeigten Beispiel kann die Kontrolleinheit 20 die Werte für das erste und zweite Zeitintervall $t_1$ und $t_2$ ausgegeben.

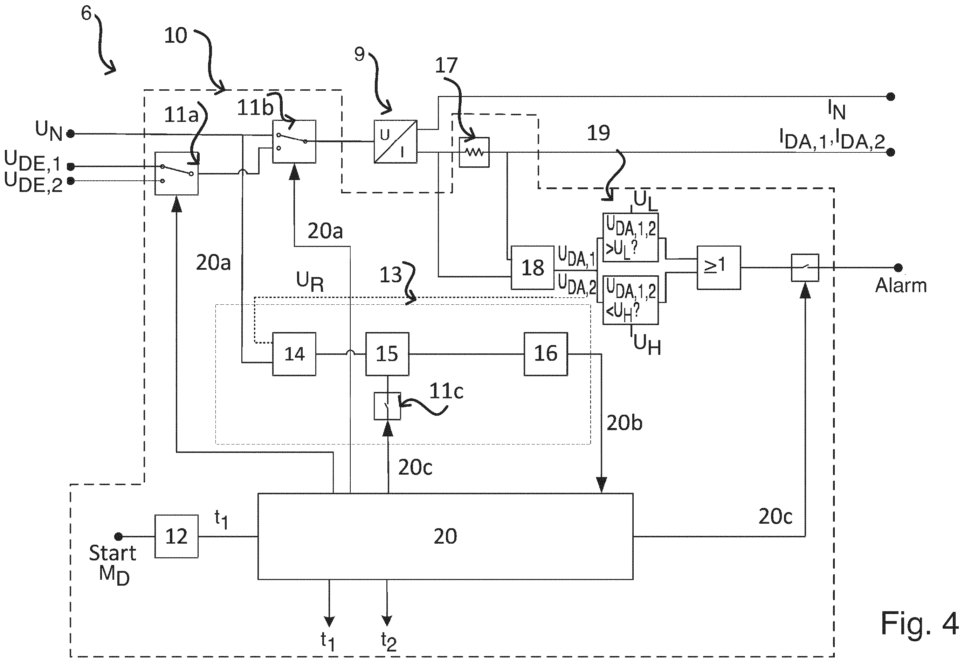

Eine zweite mögliche Ausgestaltung der Diagnoseeinheit 10 ist Gegenstand von Fig. 4. Auf bereits in Zusammenhang mit Fig. 3 erläuterte Elemente wird an dieser Stelle nicht erneut im Detail eingegangen. Im Unterschied zur in Fig. 3 dargestellten Ausgestaltung ist das Referenzsignal $U_R$ in der Ausgestaltung gemäß Fig. 4 durch das erste bzw. zweite Diagnose-Ausgangssignal $U_{DA,1}$ bzw. $U_{DA,2}$ gegeben. Durch diese Maßnahme wird berücksichtigt, dass der zeitliche Verlauf des Ausgangsstroms $I_{DA,1}$ bzw. $I_{DA,2}$ der spannungsgesteuerten Stromquelle 9 kein fehlerfreies Abbild der ersten bzw. Diagnose-Eingangsspannungen $U_{DE,1}$ bzw. $U_{DE,2}$ ist. Indem für das Referenzsignal $U_R$ also das erste bzw. zweite Diagnose-Ausgangssignal $U_{DA,1}$ bzw. $U_{DA,2}$ gewählt wird, können parasitäre Schaltungsparameter weitgehend berücksichtigt, bzw. kompensiert, werden.

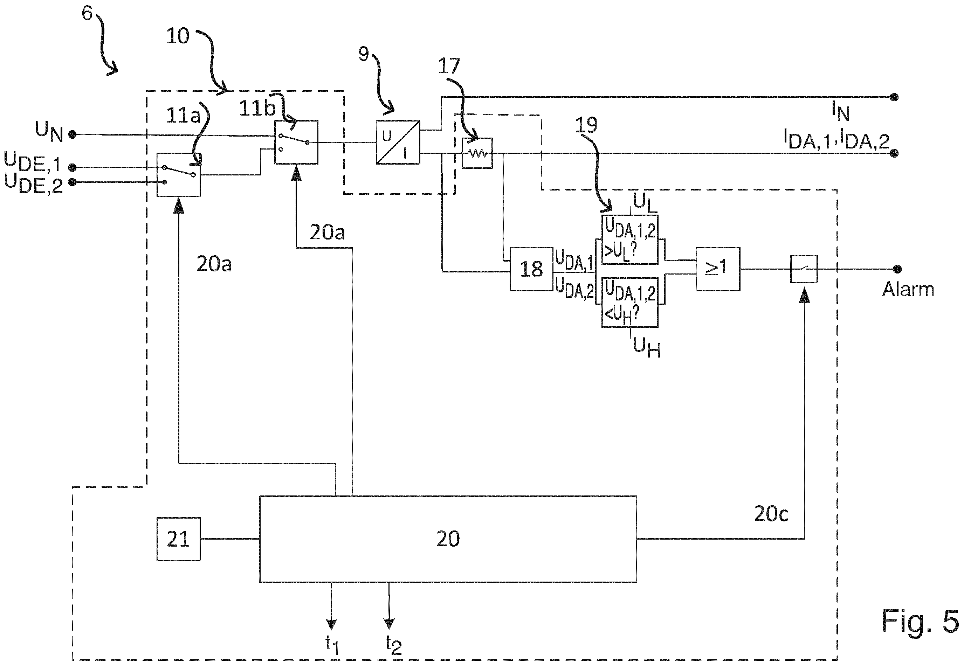

Eine dritte beispielhafte und bevorzugte Ausgestaltung der Diagnoseeinheit 10 ist schließlich in Fig. 5 gezeigt. Auch im Falle der Fig. 5 werden die bereits im Zusammenhang mit den Figuren Fig. 3 oder Fig. 4 erläuterten Elemente nicht erneut detailliert beschrieben. In dieser Ausgestaltung umfasst die Diagnoseeinheit 10 anstelle der Steuereinheit eine Recheneinheit 21, welche beispielsweise durch einen Microcontroller gegeben sein kann. Dann werden die beiden Zeitintervalle $t_1$ und $t_2$ durch die Recheneinheit 21 bestimmt. Hierzu können in der Recheneinheit 21 beispielsweise geeignete Formeln hinterlegt sein.

Neben der Möglichkeit, die Fähigkeit des Feldgeräts 1 zur Ausgabe von Fehlerinformationen zu überprüfen, können auch weitere Funktionalitäten des Feldgeräts 1 überprüft werden. Beispielsweise kann überprüft werden, ob ein in der Stromschleife eingestellter Ausgangsstrom $I_N$ dem tatsächlichen Wert der zu repräsentierenden Messgröße entspricht. Hierzu eignet sich insbesondere eine Ausgestaltung der Diagnoseeinheit 10, wie sie in Fig. 4 gezeigt ist.

Anhand des ersten Zeitintervalls $t_1$, der Eingangsspannung $U_N$ und der ersten und zweiten Diagnose-Eingangsspannung $U_{DE,1}$ und $U_{DE,2}$ kann das zweite Zeitintervall $t_2$ anhand der folgenden Formel berechnet werden:

$$t_2 = -t_1 \frac{U_N - U_{DE,1}}{U_N - U_{DE,2}}$$

Diese Formel kann nach $U_N$ umgestellt werden:

$$U_{N,ist} = \frac{t_1 U_{DE,1} + t_2 U_{DE,2}}{t_1 + t_2}$$

Der jeweilige Ausgangsstrom $I_N$ entspricht dann genau dann dem tatsächlichen Wert der zu repräsentierenden Messgröße gemäß $U_N$, wenn $U_{n,ist}=U_n$ ist.

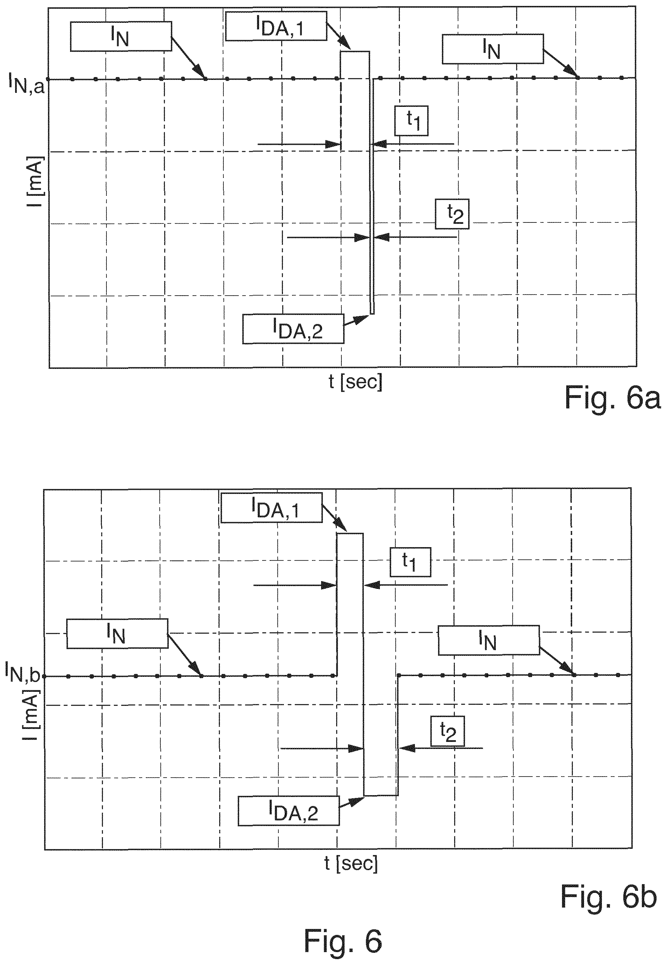

In Fig. 6 sind schematische Diagramme des ersten Ausgangsstroms $I_{DA,1}$ und des zweiten Ausgangsstroms $I_{DA,2}$ des Diagnosebetriebsmodus $M_D$ als Funktion der Zeit für verschiedene Werte für den Ausgangsstrom $I_N$ im Normalbetriebsmodus $M_N$ gezeigt. Während des Normalbetriebsmodus $M_N$ liegt der Ausgangsstrom $I_N$ im Bereich von 4-20mA. Ferner ist der Ausgangsstrom $I_{N,a}$ im Falle der Fig. 6a größer als der Ausgangsstrom $I_{N,b}$ im Falle der Fig. 6b. Es gilt $I_{N,a}>I_{N,b}$.

Während des ersten Zeitintervalls $t_1$ des Diagnosebetriebsmodus wird die erste Diagnose-Eingangsspannung $U_{DE,1}$ bereitgestellt. Entsprechend erhöht sich der Strom auf den Wert $I_{DA,1}$ erhöht. Während des zweiten Zeitintervalls wird dagegen die zweite Diagnose-Eingangsspannung $U_{DE,2}$ bereitgestellt, so dass der Strom auf den Wert $I_{DA,2}$ sinkt. Nach dem zweiten Zeitintervall beträgt der Ausgangsstrom wieder $I_{N,a}$. Die Flächeninhalte der zeitlichen Integrale der Differenz des ersten $I_{DA,1}$ und zweiten Ausgangsstroms $I_{DA,2}$ und des Ausgangsstroms $I_N$ im Normalbetriebsmodus $M_N$ über das erste $t_1$ und zweite Zeitintervall $t_2$ sind im Wesentlichen vom Betrag her gleich, so dass sich vorteilhaft eine gleichanteilsfreie Modulation des Ausgangsstroms $I_N$ ergibt. In Fig. 6b ist dasselbe Diagramm wie in Fig. 6a gezeigt, wobei der Ausgangsstrom $I_{N,b}$ während des Normalbetriebsmodus $M_N$ kleiner ist als im Falle der Fig. 6a. Zur Gewährleistung einer gleichanteilsfreien Modulation muss in diesem Falle das zweite Zeitintervall $t_2$ länger gewählt werden als im Falle der Fig. 6a. Die Dauer des zweiten Zeitintervalls $t_2$ hängt dabei grundsätzlich von der Eingangsspannung $U_N$ ab.

**Bezugszeichenliste**

| | |
|---|---|
| 1 | Feldgerät |
| 2 | Medium |
| 2a | Behälter |
| 3 | Sensoreinheit |
| 4 | Schwingfähige Einheit in Form einer Schwinggabel |
| 5 | Antriebs-/Empfangseinheit |
| 6 | Elektronik |
| 7 | Elektrode |
| 8 | Elektrode |
| 9 | Spannungsgesteuerte Stromquelle |
| 10 | Diagnoseeinheit |
| 11a-11c | Schaltelemente |
| 12 | Monostabiler Vibrator |
| 13 | Steuer-Einheit |
| 14 | Subtrahier-Einheit |
| 15 | Integrator-Einheit |
| 16 | Komparator |
| 17 | Widerstand |
| 18 | Subtrahier-Einheit |
| 19 | Komparator |
| 20 | Kontrolleinheit (20a-20d Funktionen der Kontrolleinheit) |
| 21 | Recheneinheit |
| $M_N$ | Normalbetriebsmodus |
| $M_D$ | Diagnosebetriebsmodus |
| $U_N$ | Eingangsspannung |
| $i_n$ | Ausgangsstrom |
| $U_{DE,1}$, $U_{DE,2}$ | erste, zweite Diagnose-Eingangsspannung |
| $I_{DA,1}$, $I_{DA,2}$ | erster, zweiter Diagnose-Ausgangsstrom |
| $U_{DA,1}$, $U_{DA,2}$ | erste, zweite Diagnose-Ausgangsspannung |
| $t_1$, $t_2$ | erstes, zweites Zeitintervall |
| $U_H$ | vorgebbarer Maximalwert für den Ausgangsstrom |
| $U_L$ | vorgebbarer Minimalwert für den Ausgangsstrom |

**Patentansprüche**

1. Verfahren zur Diagnose eines Zwei-Leiter-Feldgeräts (1) zur Bestimmung und/oder Überwachung zumindest einer Prozessgröße eines Mediums (2) in einem Behälter (2a),

 wobei in einem Normalbetriebsmodus ($M_N$) eine Eingangsspannung ($U_N$) bereitgestellt und ein Ausgangsstrom ($I_N$) ausgegeben wird, und wobei in einem Diagnosebetriebsmodus ($M_D$) eine Funktionalität des Zwei-Leiter-Feldgeräts (1) überprüft wird, wobei der Diagnosebetriebsmodus ($M_D$) zumindest folgende Verfahrensschritte umfasst:

 Bereitstellen einer ersten Diagnose-Eingangsspannung ($U_{DE,1}$) und Ausgeben eines ersten Diagnose-Ausgangsstroms ($I_{DA,1}$) während eines ersten Zeitintervalls

($t_1$),
Bereitstellen einer zweiten Diagnose-Eingangsspannung ($U_{DE,2}$) und Ausgeben eines zweiten Diagnose-Ausgangsstroms ($I_{DA,2}$) während eines zweiten Zeitintervalls ($t_2$),
Bestimmen des zweiten Zeitintervalls ($t_2$) ausgehend vom ersten Zeitintervall ($t_1$),
Erfassen einer ersten ($U_{DA,1}$) Diagnose-Ausgangsspannung in Abhängigkeit vom ersten ($I_{DA,1}$) Diagnose-Ausgangsstrom und einer zweiten Diagnose-Ausgangsspannung (UDA,2) in Abhängigkeit vom zweiten Diagnose-Ausgangsstrom ($I_{DA,2}$), und
Überprüfen der Funktionalität des Zwei-Leiter-Feldgeräts (1) anhand der ersten ($U_{DE,1}$) und zweiten Diagnose-Eingangsspannung ($U_{DE,2}$), dem ersten ($t_1$) und zweiten Zeitintervall ($t_2$), des ersten ($I_{DA,1}$) und zweiten Diagnose-Ausgangsstroms ($I_{DA,2}$), der ersten ($U_{DA,1}$) und zweiten Diagnose-Ausgangsspannung ($U_{DA,2}$) anhand der Eingangsspannung ($U_N$) und anhand des Ausgangsstroms ($I_N$),

**dadurch gekennzeichnet, dass**
das zweite Zeitintervall ($t_2$) ausgehend vom ersten Zeitintervall ($t_1$) derart bestimmt wird, dass ein Wert eines ersten Integrals einer Differenz zwischen der Eingangsspannung ($U_N$) und der ersten Diagnose-Eingangsspannung ($U_{DE,1}$) über das erste Zeitintervall ($t_1$) und ein Wert eines zweiten Integrals einer Differenz der Eingangsspannung ($U_N$) und der zweiten Diagnose-Eingangsspannung ($U_{DE,2}$) über das zweite Zeitintervall ($t_2$) im Wesentlichen vom Betrag her gleich sind.

2. Verfahren nach Anspruch 1,
wobei überprüft wird,

ob mittels des Zwei-Leiter-Feldgeräts (1) ein vorgebbarer Fehlerstrom, insbesondere ein vorgebbarer Maximalwert ($U_H$) oder ein vorgebbarer Minimalwert ($U_L$) für den Ausgangsstrom ($I_N$), ausgebbar ist,
ob ein zu einer vorgebbaren Eingangsspannung ($U_N$) gehöriger Ausgangsstrom ($I_N$) mit einem Fehler behaftet ist, und/oder
ob ein Defekt in der Elektronik (6) vorliegt.

3. Verfahren nach zumindest einem der vorherigen Ansprüche,
wobei das zweite Zeitintervall ($t_2$) in Abhängigkeit der Eingangsspannung ($U_N$) bestimmt wird.

4. Zwei-Leiter-Feldgerät (1) zur Bestimmung und/oder Überwachung zumindest einer Prozessgröße eines Mediums (2) in einem Behälter (2a) umfassend eine Elektronik (6) mit einer Diagnoseeinheit (10),

wobei die Elektronik (6) dazu ausgestaltet ist, in einem Normalbetriebsmodus ($M_N$) eine Eingangsspannung ($U_N$) bereitzustellen und einen Ausgangsstrom ($I_N$) auszugeben, und
in einem Diagnosebetriebsmodus ($M_D$) eine Funktionalität des Zwei-Leiter-Feldgeräts (1) zu überprüfen,
wobei die Diagnoseeinheit (10) dazu ausgestaltet ist,

während eines ersten Zeitintervalls ($t_1$) eine erste Diagnose-Eingangsspannung ($U_{DE,1}$) bereitzustellen und einen ersten Diagnose-Ausgangsstrom ($I_{DA,1}$) auszugeben,
während eines zweiten Zeitintervalls ($t_2$) eine zweite Diagnose-Eingangsspannung ($U_{DE,2}$) bereitzustellen und einen zweiten Diagnose-Ausgangsstrom ($I_{DA,2}$) auszugeben,
das zweite Zeitintervall ($t_2$) ausgehend vom ersten Zeitintervall ($t_1$) zu bestimmen,
in Abhängigkeit vom ersten Diagnose-Ausgangsstrom ($I_{DA,1}$) eine erste Diagnose-Ausgangsspannung ($U_{DA,1}$) und in Abhängigkeit vom zweiten Diagnose-Ausgangsstrom (IDA,2) eine zweite Diagnose-Ausgangsspannung ($U_{DA,2}$) zu erfassen, und anhand der ersten ($U_{DE,1}$) und zweiten Diagnose-Eingangsspannung ($U_{DE,2}$), dem ersten ($t_1$) und zweiten Zeitintervall ($t_2$), des ersten ($I_{DA,1}$) und

zweiten Diagnose-Ausgangsstroms ($I_{DA,2}$), der ersten ($U_{DA,1}$) und
zweiten Diagnose-Ausgangsspannung ($U_{DA,2}$), anhand der Eingangsspannung ($U_N$) und anhand des Ausgangsstroms ($I_N$) die Funktionalität des Zwei-Leiter-Feldgeräts (1) zu überprüfen,
**dadurch gekennzeichnet, dass** das zweite Zeitintervall (t2) ausgehend vom ersten Zeitintervall (t1) derart bestimmt wird, dass ein Wert eines ersten Integrals einer Differenz zwischen der Eingangsspannung (UN) und der ersten Diagnose-Eingangsspannung (UDE,1) über das erste Zeitintervall (t1) und ein Wert eines zweiten Integrals einer Differenz der Eingangsspannung (UN) und der zweiten Diagnose-Eingangsspannung (UDE,2) über das zweite Zeitintervall (t2) im Wesentlichen vom Betrag her gleich sind.

5. Zwei-Leiter-Feldgerät (1) nach Anspruch 4,
wobei die Elektronik (6) zumindest ein Schaltelement (11a-11c) umfasst.

**6.** Zwei-Leiter-Feldgerät (1) nach Anspruch 4 oder 5, wobei die Elektronik (6) zumindest einen Widerstand (R) umfasst, welcher zur Erzeugung der ersten ($U_{DA,1}$) und/oder zweiten Diagnose-Ausgangsspannung ($U_{DA,2}$) dient.

**7.** Zwei-Leiter-Feldgerät (1) nach zumindest einem der Ansprüche 4-6, wobei die Diagnoseeinheit (10) eine Recheneinheit (21) umfasst, welche Recheneinheit (21) dazu ausgestaltet ist, das zweite Zeitintervall ($t_2$) zumindest anhand des ersten Zeitintervalls ($t_1$) zu ermitteln.

**8.** Zwei-Leiter-Feldgerät (1) nach zumindest einem der Ansprüche 4-7, wobei die Diagnoseeinheit (10) eine Steuereinheit (13) umfasst, welche Steuereinheit (13) zumindest eine Subtrahier-Einheit (14), eine Integrator-Einheit (15) und einen Komparator (16) aufweist.

**9.** Zwei-Leiter-Feldgerät (1) nach Anspruch 8, wobei die Integrator-Einheit (15) zumindest einen Kondensator (C) und einen Widerstand (R) umfasst.

**10.** Zwei-Leiter-Feldgerät (1) nach zumindest einem der Ansprüche 8 oder 9, wobei die Integrator-Einheit (15) zumindest ein Schaltelement (11c) umfasst, welches insbesondere derart angeordnet und/oder ausgestaltet ist, dass die Integrator-Einheit (15) durch ein Betätigen des Schaltelements (11c) vor Beginn des Diagnosebetriebsmodus ($M_D$) in einen vorgebbaren Ausgangszustand versetzbar ist.

**11.** Zwei-Leiter-Feldgerät (1) nach Anspruch 8-10, wobei die Subtrahier-Einheit (14) dazu ausgestaltet ist, die Differenz zwischen einem Referenzsignal ($U_R$) und der Eingangsspannung ($U_N$) zu ermitteln.

**12.** Zwei-Leiter-Feldgerät (1) nach Anspruch 11, wobei es sich bei dem Referenzsignal ($U_R$) um die erste ($U_{DE,1}$) und/oder zweite Diagnose-Eingangsspannung ($U_{DE,2}$) oder um die erste ($U_{DA,1}$) und/oder zweite Diagnose-Ausgangsspannung ($U_{DA,2}$) handelt.

**13.** Zwei-Leiter-Feldgerät (1) nach zumindest einem der Ansprüche 8-12, wobei der Komparator (16) dazu ausgestaltet ist, das zweite Zeitintervall ($t_2$) anhand einer Eingangsspannung der Integrator-Einheit, zu ermitteln.

**14.** Zwei-Leiter-Feldgerät (1) nach zumindest einem der Ansprüche 4-13, wobei die Elektronik (6) einen monostabilen Multivibrator (12) umfasst.

**Claims**

**1.** Procedure for the diagnosis of a two-wire field device (1) designed to determine and/or monitor at least a process variable of a medium (2) in a vessel (2a),

wherein, in a normal operating mode ($M_N$), an input voltage ($U_N$) is provided and an output current ($I_N$) is output, and
wherein, in a diagnostic operating mode ($M_D$), a functionality of the two-wire field device (1) is checked, wherein the diagnostic operating mode ($M_D$) at least comprises the following procedural steps:

Provision of a first diagnostic input voltage ($U_{DE,1}$) and outputting of a first diagnostic output current ($I_{DA,1}$) during a first time interval ($t_1$),
Provision of a second diagnostic input voltage ($U_{DE,2}$) and outputting of a second diagnostic output current ($I_{DA,2}$) during a second time interval ($t_2$),
Determination of the second time interval ($t_2$) starting from the first time interval ($t_1$)
Determination of a first diagnostic output voltage ($U_{DA,1}$) depending on the first diagnostic output current ($I_{DA,1}$) and a second diagnostic output voltage ($U_{DA,2}$) depending on the second diagnostic output current ($I_{DA,2}$), and
Verification of the functionality of the two-wire field device (1) using the first ($U_{DE,1}$) and the second diagnostic input voltage ($U_{DE,2}$), the first ($t_1$) and the second time interval ($t_2$), the first ($I_{DA,1}$) and the second diagnostic output current ($I_{DA,2}$), the first ($U_{DA,1}$) and the second diagnostic output voltage ($U_{DA,2}$), using the input voltage ($U_N$) and the output current ($I_N$),

**characterized in that**
the second time interval ($t_2$) is determined from the first time interval ($t_1$) in such a way that a value of a first integral of a difference between the input voltage ($U_N$) and the first diagnostic input voltage ($U_{DE,1}$) over the first time interval ($t_1$) and a value of a second integral of a difference between the input voltage ($U_N$) and the second diagnostic input voltage ($U_{DE,2}$) over the second time interval ($t_2$) are essentially equal in terms of the absolute value.

**2.** Procedure as claimed in Claim 1, wherein a check is performed to determine

whether a predeterminable failure current, particularly a predeterminable maximum value ($U_H$) or a predeterminable minimum value ($U_L$) for the output current ($I_N$) can be output by means of the two-wire field device (1),
whether an output current ($I_N$) pertaining to a predeterminable input voltage ($U_N$) has an error, and/or
whether there is a defect in the electronics unit (6).

3. Procedure as claimed in at least one of the previous claims,
   wherein the second time interval ($t_2$) is determined depending on the input voltage ($U_N$).

4. Two-wire field device (1) for determining and/or monitoring at least a process variable of a medium (2) in a vessel (2a), comprising an electronics unit (6) with a diagnostic unit (10),

   wherein the electronics unit (6) is designed to provide an input voltage ($U_N$) in a normal operating mode ($M_N$) and to output an output current ($I_N$), and
   to check a functionality of the two-wire field device (1) in a diagnostic operating mode ($M_D$),
   wherein the diagnostic unit (10) is designed

   to provide a first diagnostic input voltage ($U_{DE,1}$) and to output a first diagnostic output current ($I_{DA,1}$) during a first time interval ($t_1$),
   to provide a second diagnostic input voltage ($U_{DE,2}$) and to output a second diagnostic output current ($I_{DA,2}$) during a second time interval ($t_2$),
   to determine the second time interval ($t_2$) starting from the first time interval ($t_1$),
   to measure a first diagnostic output voltage depending on the first diagnostic output current ($I_{DA,1}$) and to measure a second diagnostic output voltage ($U_{DA,2}$) depending on the second diagnostic output current ($I_{DA,2}$), and to check the functionality of the two-wire field device (1) using the first ($U_{DE,1}$) and the second diagnostic input voltage ($U_{DE,2}$), the first ($t_1$) and the second time interval ($t_2$), the first ($I_{DA,1}$) and the second diagnostic output current ($I_{DA,2}$), the first ($U_{DA,1}$) and the second diagnostic output voltage ($U_{DA,2}$), using the input voltage ($U_N$) and using the output current ($I_N$),

   **characterized in that** the second time interval ($t_2$) is determined starting from the first time interval ($t_1$) in such a way that a value of a first integral of a difference between the input voltage ($U_N$) and the first diagnostic input voltage ($U_{DE,1}$) over the first time interval ($t_1$) and a value of a second integral of a difference between the input voltage ($U_N$) and the second diagnostic input voltage ($U_{DE,2}$) over the second time interval ($t_2$) are essentially equal in terms of the absolute value.

5. Two-wire field device (1) as claimed in Claim 4, wherein the electronics unit (6) comprises at least a switching element (11a-11c).

6. Two-wire field device (1) as claimed in Claim 4 or 5, wherein the electronics unit (6) comprises at least a resistor (R) which serves to generate the first ($U_{DA,1}$) and/or the second diagnostic output voltage ($U_{DA,2}$).

7. Two-wire field device (1) as claimed in at least one of the Claims 4 to 6,
   wherein the diagnostic unit (10) comprises a computing unit (21), wherein said computing unit (21) is designed to determine the second time interval ($t_2$) at least using the first time interval ($t_1$).

8. Two-wire field device (1) as claimed in at least one of the Claims 4 to 7,
   wherein the diagnostic unit (10) comprises a control unit (13), wherein said control unit (13) comprises at least a subtraction unit (14), an integrator unit (15) and a comparator (16).

9. Two-wire field device (1) as claimed in Claim 8, wherein the integrator unit (15) comprises at least a capacitor (C) and a resistor (R).

10. Two-wire field device (1) as claimed in at least one of the Claims 8 or 9,
    wherein the integrator unit (15) comprises at least a switching element (11 c), wherein said element is particularly arranged and/or designed in such a way that the integrator unit (15) can be set to a predeterminable initial state by operating the switching element (11c) before the start of the diagnostic operating mode ($M_D$).

11. Two-wire field device (1) as claimed in one of the Claims 8 to 10,
    wherein the subtraction unit (14) is designed to determine the difference between a reference signal ($U_R$) and the input voltage ($U_N$).

12. Two-wire field device (1) as claimed in Claim 11, wherein the reference signal ($U_R$) is the first ($U_{DE,1}$) and/or the second diagnostic input voltage ($U_{DE,2}$) or the first ($U_{DA,1}$) and/or the second diagnostic output voltage ($U_{DA,2}$).

13. Two-wire field device (1) as claimed in at least one of the Claims 8 to 12,
    wherein the comparator (16) is designed to determine the second time interval ($t_2$) using an input voltage of the integrator unit.

**14.** Two-wire field device (1) as claimed in at least one of the Claims 4 to 13, wherein the electronics unit (6) comprises a monostable multivibrator (12).

**Revendications**

**1.** Procédé destiné au diagnostic d'un appareil de terrain 2 fils (1) destiné à la détermination et/ou à la surveillance d'au moins une grandeur de process d'un produit (2) dans un réservoir (2a),

procédé pour lequel, dans un mode de fonctionnement normal ($M_N$), une tension d'entrée ($U_N$) est mise à disposition et un courant de sortie ($I_N$) est émis, et

procédé pour lequel, dans un mode de fonctionnement de diagnostic ($M_D$), une fonctionnalité de l'appareil de terrain 2 fils (1) est contrôlée, le mode de fonctionnement de diagnostic ($M_D$) comprenant au moins les étapes de procédé suivantes :

Mise à disposition d'une première tension d'entrée de diagnostic ($U_{DE,1}$) et émission d'un premier courant de sortie de diagnostic ($I_{DA,1}$) pendant un premier intervalle de temps ($t_1$),

Mise à disposition d'une deuxième tension d'entrée de diagnostic ($U_{DE,2}$) et émission d'un deuxième courant de sortie de diagnostic ($I_{DA,2}$) pendant un deuxième intervalle de temps ($t_2$),

Mesure d'une première tension de sortie de diagnostic ($U_{DA,1}$) en fonction du premier courant de sortie de diagnostic ($I_{DA,1}$) et d'une deuxième tension de sortie de diagnostic ($U_{DA,2}$) en fonction du deuxième courant de sortie de diagnostic ($I_{DA,2}$), et

Vérification de la fonctionnalité de l'appareil de terrain 2 fils (1) à l'aide de la première ($U_{DE,1}$) et de la deuxième tension d'entrée de diagnostic ($U_{DE,2}$), du premier ($t_1$) et du deuxième intervalle de temps ($t_2$), du premier ($I_{DA,1}$) et du deuxième courant de sortie de diagnostic ($I_{DA,2}$), de la première ($U_{DA,1}$) et de la deuxième tension de sortie de diagnostic ($U_{DA,2}$), à l'aide de la tension d'entrée ($U_N$) et à l'aide du courant de sortie ($I_N$),

**caractérisé en ce que**
le deuxième intervalle de temps ($t_2$) est déterminé à partir du premier intervalle de temps ($t_1$) de telle sorte qu'une valeur d'une première intégrale d'une différence entre la tension d'entrée ($U_N$) et la première tension d'entrée de diagnostic ($U_{DE,1}$) sur le premier intervalle de temps ($t_1$) et une valeur d'une deuxième intégrale d'une différence entre la tension d'entrée

($U_N$) et la deuxième tension d'entrée de diagnostic ($U_{DE,2}$) sur le deuxième intervalle de temps ($t_2$) sont pour l'essentiel égales en valeur absolue.

**2.** Procédé selon la revendication 1, pour lequel on vérifie

si un courant de défaut prédéfinissable, notamment une valeur maximale ($U_H$) prédéfinissable ou une valeur minimale ($U_L$) prédéfinissable pour le courant de sortie ($I_N$), peut être délivré au moyen de l'appareil de terrain 2 fils (1), si un courant de sortie ($I_N$) appartenant à une tension d'entrée ($U_N$) prédéfinissable est entaché d'un défaut, et/ou si un défaut est présent dans l'électronique (6).

**3.** Procédé selon au moins l'une des revendications précédentes, pour lequel le deuxième intervalle de temps ($t_2$) est déterminé en fonction de la tension d'entrée ($U_N$).

**4.** Appareil de terrain 2 fils (1) destiné à la détermination et/ou à la surveillance d'au moins une grandeur de process d'un produit (2) dans un réservoir (2a), lequel appareil comprend une électronique (6) avec une unité de diagnostic (10),

l'électronique (6) étant conçue pour mettre à disposition une tension d'entrée ($U_N$) dans un mode de fonctionnement normal ($M_N$) et pour délivrer un courant de sortie ($I_N$), et dans un mode de fonctionnement de diagnostic ($M_D$), à vérifier une fonctionnalité de l'appareil de terrain 2 fils (1), l'unité de diagnostic (10) étant conçue de telle sorte

à fournir une première tension d'entrée de diagnostic ($U_{DE,1}$) et à délivrer un premier courant de sortie de diagnostic ($I_{DA,1}$) pendant un premier intervalle de temps ($t_1$), à fournir une deuxième tension d'entrée de diagnostic ($U_{DE,2}$) et à délivrer un deuxième courant de sortie de diagnostic ($I_{DA,2}$) pendant un deuxième intervalle de temps ($t_2$), à déterminer le deuxième intervalle de temps ($t_2$) à partir du premier intervalle de temps ($t_1$), à mesurer, en fonction du premier courant de sortie de diagnostic ($I_{DA,1}$), une première tension de sortie de diagnostic et à mesurer, en fonction du deuxième courant de sortie de diagnostic ($I_{DA,2}$), une deuxième tension de sortie de diagnostic ($U_{DA,2}$), et et - à l'aide de la première ($U_{DE,1}$) et de la deuxième tension d'entrée de diagnostic ($U_{DE,2}$), du premier ($t_1$) et du deuxième in-

tervalle de temps ($t_2$), du premier ($I_{DA,1}$) et du deuxième courant de sortie de diagnostic ($I_{DA,2}$), de la première ($U_{DA,1}$) et de la deuxième tension de sortie de diagnostic ($U_{DA,2}$), à l'aide de la tension d'entrée ($U_N$) et à l'aide du courant de sortie ($I_N$) - à vérifier la fonctionnalité de l'appareil de terrain 2 fils (1),

**caractérisé en ce que** le deuxième intervalle de temps ($t_2$) est déterminé à partir du premier intervalle de temps ($t_1$) de telle sorte qu'une valeur d'une première intégrale d'une différence entre la tension d'entrée ($U_N$) et la première tension d'entrée de diagnostic ($U_{DE,1}$) sur le premier intervalle de temps ($t_1$) et une valeur d'une deuxième intégrale d'une différence entre la tension d'entrée ($U_N$) et la deuxième tension d'entrée de diagnostic ($U_{DE,2}$) sur le deuxième intervalle de temps ($t_2$) sont pour l'essentiel égales en valeur absolue.

5. Appareil de terrain 2 fils (1) selon la revendication 4, pour lequel l'électronique (6) comprend au moins un élément de commutation (11a-11c).

6. Appareil de terrain 2 fils (1) selon la revendication 4 ou 5, pour lequel l'électronique (6) comprend au moins une résistance (R) qui sert à générer la première ($U_{DA,1}$) et/ou la deuxième tension de sortie de diagnostic (UDA,2).

7. Appareil de terrain 2 fils (1) selon au moins l'une des revendications 4 à 6, pour lequel l'unité de diagnostic (10) comprend une unité de calcul (21), laquelle unité de calcul (21) est conçue pour déterminer le deuxième intervalle de temps ($t_2$) au moins à l'aide du premier intervalle de temps ($t_1$).

8. Appareil de terrain 2 fils (1) selon au moins l'une des revendications 4 à 7, pour lequel l'unité de diagnostic (10) comprend une unité de commande (13), laquelle unité de commande (13) comprend au moins une unité de soustraction (14), une unité d'intégration (15) et un comparateur (16).

9. Appareil de terrain 2 fils (1) selon la revendication 8, pour lequel l'unité d'intégration (15) comprend au moins un condensateur (C) et une résistance (R).

10. Appareil de terrain 2 fils (1) selon au moins l'une des revendications 8 ou 9, pour lequel l'unité d'intégration (15) comprend au moins un élément de commutation (11c), lequel élément est notamment disposé et/ou conçu de telle sorte que l'unité d'intégration (15) peut être mise dans un état initial prédéfinissable par un actionnement de l'élément de commutation (11c) avant le début du mode de fonctionnement de diagnostic ($M_D$).

11. Appareil de terrain 2 fils (1) selon l'une des revendications 8 à 10, pour lequel l'unité de soustraction (14) est conçue pour déterminer la différence entre un signal de référence ($U_R$) et la tension d'entrée ($U_N$).

12. Appareil de terrain 2 fils (1) selon la revendication 11, pour lequel le signal de référence ($U_R$) est la première ($U_{DE,1}$) et/ou la deuxième tension d'entrée de diagnostic ($U_{DE,2}$) ou la première ($U_{DA,1}$) et/ou la deuxième tension de sortie de diagnostic ($U_{DA,2}$).

13. Appareil de terrain 2 fils (1) selon au moins l'une des revendications 8 à 12, pour lequel le comparateur (16) est conçu pour déterminer le deuxième intervalle de temps ($t_2$) à l'aide d'une tension d'entrée de l'unité d'intégration.

14. Appareil de terrain 2 fils (1) selon au moins l'une des revendications 4 à 13, pour lequel l'électronique (6) comprend un multivibrateur monostable (12).

Fig. 1

Fig. 2

Fig. 3

Fig. 4

Fig. 5

EP 3 807 733 B1

Fig. 6a

Fig. 6b

Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2005168343 A1
- EP 1860513 A1
- US 7098798 B2
- DE 02008001832 A1